# EUROPEAN PATENT APPLICATION

(11) **EP 4 502 229 A1**
(43) Date of publication of application: **05.02.2025**
(21) Application number: 24163362.7
(22) Date of filing: 13.03.2024
(51) Int. Cl.: C23C 16/34, H01L 21/02

(54) **PECVD METHOD AND APPARATUS**

(30) Priority: 31.07.2023 GB 202311757
(71) Applicant: SPTS Technologies Limited, Newport Gwent NP18 2TA (GB)
(72) Inventor: CROOK, Kathrine, Newport (GB); ANTONIOU, Giorgos, Newport (GB)
(74) Representative: Wynne-Jones IP Limited

(57) **Abstract**

A method of depositing silicon nitride onto a semiconductor substrate by plasma enhanced chemical vapour deposition (PECVD), a structure comprising a semiconductor substrate and a plasma enhanced chemical vapour deposition (PECVD) apparatus for depositing silicon nitride onto a semiconductor substrate by PECVD are provided.

## Description

This invention relates to a plasma enhanced chemical vapour deposition (PECVD) method, in particular a method of depositing silicon nitride onto a semiconductor substrate by PECVD. The invention relates also to an associated PECVD apparatus. Further, the invention relates to structures comprising a semiconductor substrate with deposited layers of silicon nitride.

### Background

The maintenance of a relatively flat substrate during the processing of semiconductor substrates is an important consideration. This is in part to due to patterning requirements but it is also necessitated by the nature of the automated processes used to handle the substrate. As material is removed or added to the substrate and it is heat cycled, stresses can build up in the substrate which result in its deformation. This problem is exacerbated following wafer thinning steps as the stresses of the deposited layers on the substrate result in greater deformation when the substrate thickness is reduced.

It is known to balance the stresses of layers used in applications (such as 3D memory) where multiple alternate layers of SiN and SiO are used in forming the device. Layers alternate between compressive and tensile stress with the objective to balance the net stress of the many layers - potentially greater than 128 layers. Alternatively, material can be deposited on opposite sides of the substrate to achieve a stress balancing effect. This can be achieved by conventional physical vapour deposition (PVD), chemical vapour deposition (CVD) or PECVD depositions. A compressive or tensile stress on one side of the substrate can be balanced by an equal compressive or tensile stress on the other side of the substrate.

Highly stressed layers are highly undesirable. This is because they have can be susceptible to cracking and particle generation, which can result in defectivity and reliability concerns. It is therefore essential that the material deposition technique and process is carefully considered when stress control layers are used.

In general, a front surface of the semiconductor substrate is processed to provide a number of desired structures. The front surface is sometimes alternatively referred to as a 'device surface', since the structures typically provide a desired functionality. After processing, the semiconductor substrate is typically divided by one of a number of known processes to provide a plurality of devices. In many cases, the structures on the device side are sensitive and the risk of damage to the structures means that it is not viable to contact the device surface in the region of the structures, for example to perform a further processing step aimed at reducing the stress that the substrate is subject to. However, this stress can produce substrate warpage which may be so great that the substrate transport system and module is not able to process the substrate without risking a mishandling event. Recovery from mishandling frequently results in the part being damaged and the system being vented to atmosphere to be cleaned and reconditioned.

### Statement of Invention

The present invention, in at least some of its embodiments, seeks to address at least some of the above-mentioned problems and wants. In particular, the present invention allows the stress (that a semiconductor substrate is subject to) to be reduced using a process that does not require contact with structures formed on a front surface of the semiconductor substrate. In this way, the degree of bowing of the semiconductor substrate can be reduced.

According to a first aspect of the invention there is provided a method of depositing silicon nitride onto a semiconductor substrate by plasma enhanced chemical vapour deposition (PECVD), the method comprising the steps of:
providing a semiconductor substrate having a front surface and a rear surface, in which the front surface comprises a central region having one or more structures formed thereon and an edge region surrounding the central region;
positioning the front surface of the semiconductor substrate on a substrate support in a chamber, wherein the substrate support only contacts the edge region of the front surface of the semiconductor substrate; and
depositing a stack of silicon nitride layers onto the rear surface of the semiconductor substrate by PECVD, wherein the stack of silicon nitride layers comprises at least four layers of silicon nitride which alternate between tensile layers which are subject to a tensile stress and compressive layers which are subject to a compressive stress.

The stack of silicon nitride layers can comprise at least eight layers of silicon nitride. The stack of silicon nitride layers can have a thickness of 3 microns or greater. The stack of silicon nitride layers can have a thickness of 5 microns or greater. The layers of silicon nitride can each have a thickness, and the thickness of the tensile layers can be greater than the thickness of the compressive layers. The tensile layers can be at least twice as thick as the compressive layers. The tensile layers can be at least four times as thick as the majority of the compressive layers. The thickness of the tensile layers can be in the range 0.5 to 2.7 microns.

The stack of silicon nitride layers can be deposited by PECVD using nitrogen, hydrogen, ammonia and silane as precursors. Other precursor mixtures can be used to deposit the SiN layers.

Prior to the step of depositing the stack of silicon nitride layers, the semiconductor substrate can have a concave bow when viewing the front surface of the semiconductor substrate. The stack of silicon nitride layers can be deposited to reduce the concave bow of the semiconductor substrate. The concave bow of the semiconductor substrate can be reduced to less than 100 microns. The concave bow of the semiconductor substrate can be reduced to about 20 microns.

The step of depositing the stack of silicon nitride layers onto the rear surface of the semiconductor substrate by PECVD can be performed using a capacitively coupled parallel plate PECVD process. At least one gas inlet can be provided for introducing a gas or gas mixture into the chamber, and the semiconductor substrate can be positioned on the substrate support with the rear surface facing towards the at least one gas inlet. In one aspect, during the step of depositing a stack of silicon nitride layers onto the rear surface of the semiconductor substrate by PECVD, the plasma associated with the PECVD does not contact the front surface of the semiconductor substrate. The semiconductor substrate can have a peripheral edge, and the substrate support can only contact the edge region of the front surface of the semiconductor substrate in a region no more than 3mm inward of the peripheral edge.

The semiconductor substrate can be a silicon substrate. The semiconductor substrate can be a semiconductor wafer.

According to a second aspect of the invention there is provided a structure comprising:
a semiconductor substrate having a front surface and a rear surface, in which the front surface comprises a central region and an edge region surrounding the central region;
one or more structures formed on the central region of the front surface of the semiconductor substrate; and
a stack of silicon nitride layers deposited onto the rear surface of the semiconductor substrate, wherein the stack of silicon nitride layers comprises at least four layers of silicon nitride which alternate between tensile layers which are subject to a tensile stress and compressive layers which are subject to a compressive stress.

The structure of the second aspect of the invention can be produced by the method according to the first aspect of the invention.

According to a third aspect of the invention there is provided a plasma enhanced chemical vapour deposition (PECVD) apparatus for depositing silicon nitride onto a semiconductor substrate by PECVD using a method according to the first aspect of the invention, the apparatus comprising:
a chamber;
a substrate support disposed within the chamber for supporting a substrate, wherein the substrate support only contacts an edge region of the substrate;
at least one gas inlet for introducing a gas or gas mixture into the chamber;
a plasma device for generating and sustaining a plasma in the chamber; and
a controller configured to control the apparatus to deposit a stack of silicon nitride layers onto the semiconductor substrate by PECVD, wherein the stack of silicon nitride layers comprises at least four layers of silicon nitride which alternate between tensile layers which are subject to a tensile stress and compressive layers which are subject to a compressive stress.

The plasma device can comprise at least one power supply device configured to supply a RF power signal to the at least one gas inlet.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. For example, any features disclosed in relation to the first aspect of the invention can be combined with any features disclosed in relation to the second aspect of the invention and *vice versa.*

### Description of Figures

Embodiments of the invention will now be described, by way of example only, with reference to the accompanying drawings, in which:
Figure 1 is a schematic cross-sectional view of a PECVD apparatus;
Figure 2 is a cross-sectional view of the edge of a substrate support;
Figure 3 shows a semiconductor substrate that has a bow;
Figure 4 shows stress and wafer bow at different thicknesses of a single SiN layer;
Figure 5 is a schematic view of a substrate with a stack of alternately tensile and compressive SiN layers;
Figure 6 shows the bow of a single tensile SiN layer and the bow of a stack of SiN layers;
Figure 7 shows stress and wafer bow at different thickness of a SiN stack; and
Figure 8 shows deflection maps as extracted from stress gauge (a) prior to SiN stack deposition and b) following deposition of the SiN stack.

### Detailed Description

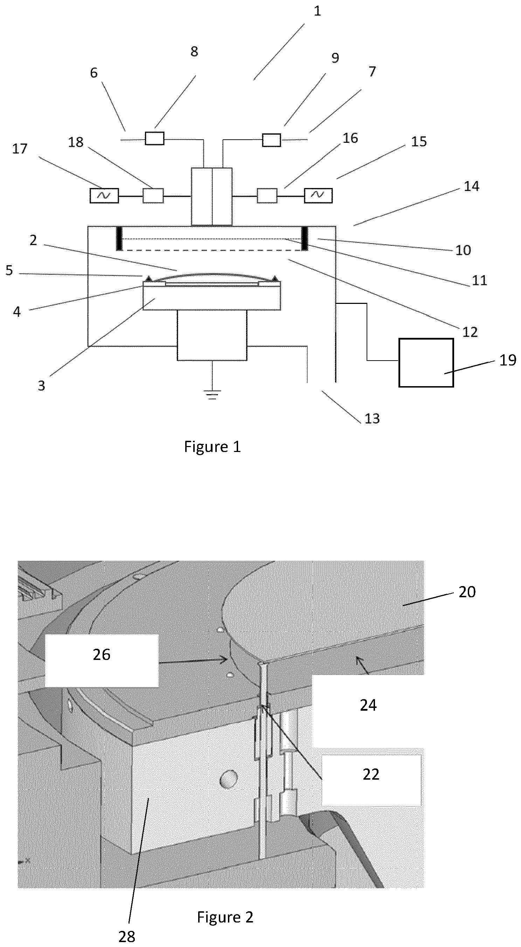

Figure 1 shows a PECVD apparatus 1 which can be used in conjunction with the invention to process a semiconductor substrate 2. The semiconductor substrate 2 can be a silicon wafer or another suitable substrate having structures already formed on a central region of its front surface. The semiconductor substrate 2 is supported on a substrate support 3,4. In this example, the substrate support comprises an essentially conventional wafer platen 3 with an attached metallic wafer carrier 4. The wafer carrier 4 defines a central cavity having a diameter which is less than the diameter of the substrate 2. When processing substrates in the form of wafers having a diameter in the range 150 to 300mm, the central cavity can have a diameter which is 6mm less than the diameter of the wafer. The substrate 2 is handled through a transport system with an edge grip end effector (not shown) and placed centrally on the substrate support 3,4 with the front (device) surface facing downwards, i.e. facing towards the substrate support 3,4. The substrate 2 is retained in position by several ceramic pins 5 that are located about 0.5mm from the edge of the substrate 2. The wafer carrier 4 ensures that the substrate 2 is only contacted at its edge region, i.e. a peripheral region which surrounds the central region where the structures are located. The edge region can correspond to the so-called 'edge exclusion' region, which is a peripheral band typically extending from the edge of the wafer to an inner diameter which is about 2 to 3mm radially inward of the edge of the wafer.

The provision of the wafer carrier 4 avoids causing damage to the front surface of the substrate 2 which would otherwise be caused if a substrate with sensitive structures on its front surface was placed onto a conventional wafer 3 support. Such damage can in turn result in yield loss and so is highly undesirable. By contacting the substrate at its edge region, it is possible to safely handle the substrate and avoid damage to active and/or yielding regions of the front surface of the wafer.

Further elements of the PECVD apparatus 1 of Figure 1 will now be described. Precursor process gases pass through gas lines 6, 7 and valves 8, 9 and enter a showerhead gas inlet 10 where they expand and pass through an optional gas distribution plate 11 before entering the process chamber 14 through a series of small openings 12 in the front surface of the showerhead 10. Exhaust gases pass through opening 13 to be removed by a pumping system (not shown). The process pressure in the chamber 14 is monitored and maintained by controlling gas flows and pumping speed. In use, plasma is generated using RF power. RF power is supplied by a high frequency (typically 13.56MHz) RF power supply 15 and associated matching unit 16 and a low frequency (typically 380 KHz) RF power supply 17 with an associated matching unit 18. A controller 19 controls the operation of the PECVD apparatus.

The substrate support 3,4 is grounded and uses resistive heating to control substrate temperature. The chamber 14 is also grounded and is made from aluminium or stainless steel. The showerhead 10 is made from aluminium and is isolated from the chamber 14 by a ceramic break. To avoid unwanted plasma generation between the surface of the wafer carrier 4 and the front surface of the substrate 2, a gap of less than 0.7mm is used. For the operational pressures and RF powers typically employed in ordinary use, this provides an effective dark space gap. Deposition is therefore avoided in the region of the central cavity and onto the front surface of the substrate 2.

Figure 2 shows an adaptor arrangement that can be used in conjunction with a conventional wafer platen. In Figure 2, a substrate 20 is in a raised position on edge lift pins 22 with the central cavity 24 visible below the substrate 20. In Figure 2 the wafer carrier 26 and wafer platen 28 extend beyond the edge of the substrate 20 due to the fact that the chamber used can accommodate wafers of up to 300mm diameter. The adaptor shown in Figure 2 is used for 150mm diameter wafers, although it will be appreciated that the invention is not limited to substrates of any particular size or shape. Apparatus suitable for performing the methods of the present invention include an adapted SPTS Delta (RTM) PECVD system with edge contact adaptor hardware, which is commercially available from SPTS Technologies Limited, located in Newport, South Wales, UK. All exemplary examples described below were performed using this apparatus. Other PECVD systems, such as other capacitively coupled parallel plate PECVD systems, might be used.

With physical contact only being made on the periphery of the substrate, RF coupling to the substrate and heat transfer from the wafer support is reduced when compared to a conventional wafer support. This in turn modifies the properties of the deposited layers. Deposition of highly tensile SiN using edge-contact hardware is more difficult than with conventional, full contact as the non-uniform plasma coupling tends to result in a more brittle layer with a reduced cracking threshold in comparison with values achievable using conventional planar support. The present inventors have exploited these different operating conditions to provide improved PECVD deposited SiN layers. Despite these difficulties, the present inventors have devised a way of reducing concave warping of a substrate, by using a laminated SiN PECVD deposition process to achieve an acceptable overall stress and an acceptable bow. In some examples, a concave warping of greater than 300 microns can be reduced to an acceptable bow of less than 100 microns. In accordance with the present invention, a stack of silicon nitride layers is deposited by PECVD onto the rear surface of the semiconductor substrate, wherein the stack of silicon nitride layers comprises at least four layers of silicon nitride which alternate between tensile layers which are subject to a tensile stress and compressive layers which are subject to a compressive stress. This can allow deposition to be carried out to higher thicknesses and larger wafer bows to be corrected while preserving the integrity of structures formed on the front surface of the substrate.

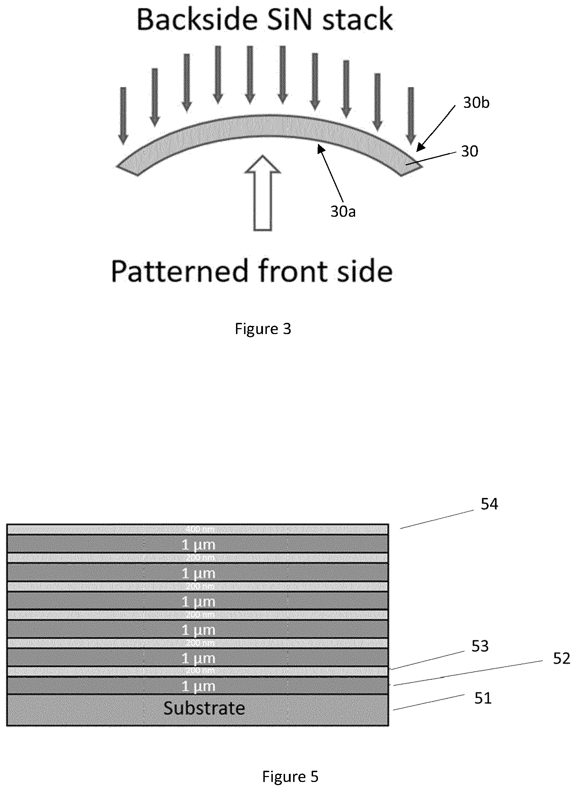

Figure 3 shows a schematic representation of a wafer 30 which due to previous process steps is concave as viewed from the front surface (device side) 30a of the wafer which carries certain structures. The term 'concave' as used herein is understood to describe the appearance of the semiconductor substrate when its front surface is viewed, as shown in Figure 3. The stack of SiN layers is deposited by PECVD onto the rear surface 30b of the wafer 30.

### Examples

Two types of 150mm diameter silicon test wafers were used: prime (flat) and concave with warping greater than 300µm. Wafer thickness is nominally 675µm.

PECVD SiN films are not pure Si₃N₄ layers but are more accurately described as SiₓN_{y}H_{z} or SiN:H as they contain significant amounts of H, potentially greater than 10at%.

High tensile stress films were deposited using the following parameters displayed in Table 1:

**Table 1: PECVD parameters for deposition of Tensile SiN**

| Parameter (Units) | Value |
|---|---|
| Pressure (Torr) | 2.6 |
| Temperature (°C) | 350 |
| HF RF (kW) | 15 |
| N₂ gas flow (sccm) | 4000 |
| H₂ gas flow (sccm) | 400 |
| NH₃ gas flow (sccm) | 624 |
| SiH₄ gas flow (sccm) | 240 |

This resulted in the film properties displayed in Table 2.

**Table 2: Film Properties for tensile SiN at 2.7 µm**

| | |
|---|---|
| Deposition Rate | 425nm/min |
| Refractive Index | 1.8804 |
| Stress | +436MPa |
| Bow (Horizontal) | -151µm |
| Bow (Vertical) | -150µm |

In Table 2 and Table 4, the negative and positive signs for the bow measurement are an indication of increased or decreased bowing deformation respectively.

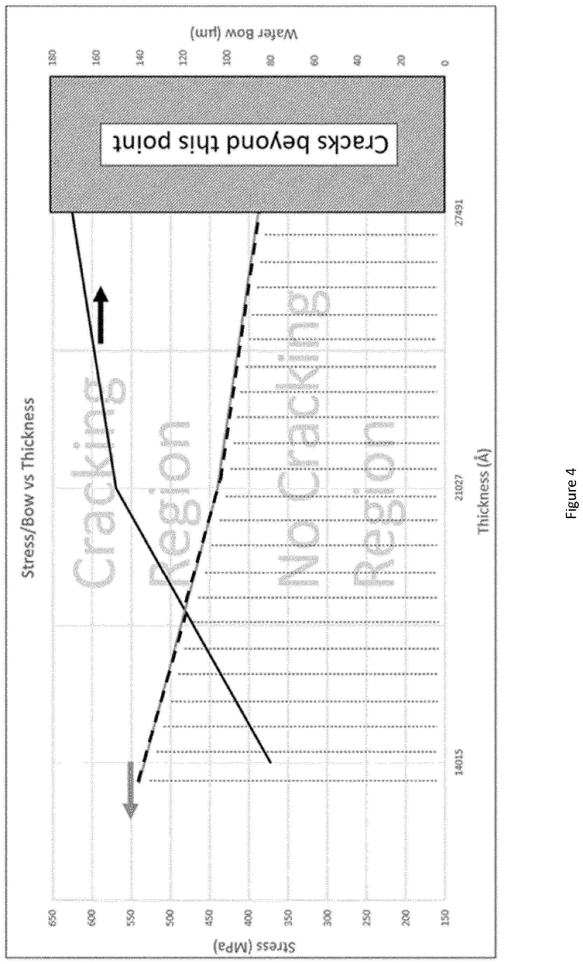

In Figure 4, wafer bow (mm) and stress (MPa) is plotted against SiN thickness (Å) on silicon wafers using the edge contact hardware using the above process conditions films. It is well known that if the thickness is increased beyond a certain value, the film begins to crack. The area below the dotted line (representing stress, marked with black dashed lines) is the region that the films show no signs of cracks, and exceeding those limits cracking is observed. Cracking occurs at greater than about 2.7µm in thickness, at which point the stress of +436MPa only produces a bow of about 150µm.

The cracking threshold is improved by depositing a stack of thin compressive and thick tensile SiN films (repeated to desired thickness and bow requirements), to reduce the overall very high tensile stresses of the SiN stack. This allows in significant increase in deposition thickness beyond the cracking threshold expected for a single tensile SiN layer at this stress. O₂ plasma treatment was used before the thin compressive SiN as an adhesion promoter. This process is proven to eliminate organic contaminants, hence providing a better layer interface. The process parameters for the compressive film are given below in Table 3:

**Table 3: PECVD parameters for deposition of Compressive SiN**

| Parameter (Units) | Value |
|---|---|
| Pressure (Torr) | 1.93 |
| Temperature (°C) | 350 |
| HF RF (kW) | 0.7 |
| N₂ gas flow (sccm) | 3400 |
| H₂ gas flow (sccm) | 1000 |
| NH₃ gas flow (sccm) | 700 |
| SiH₄ gas flow (sccm) | 350 |

The film properties of the compressive SiN film can be found in Table 4.

**Table 4. Film Properties for the compressive SiN at 1000 Å**

| | |
|---|---|
| Deposition Rate | 208nm/min |
| Refractive Index | 2.1104 |
| Stress | -286MPa |
| Bow (Horizontal) | 5µm |
| Bow (Vertical) | 4µm |

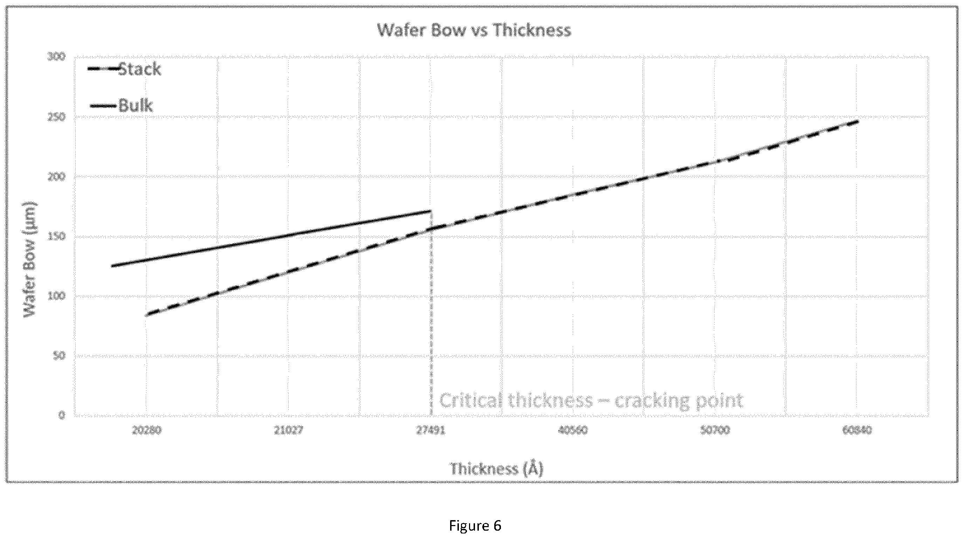

The laminated structure used can be seen in Figure 5 with the bow values for a single tensile SiN film and the stack displayed in Figure 6. Tensile SiN layers 52 having a thickness of 1 µm and compressive SiN layer 53 having a thickness of 200 nm are alternated until a desired thickness and/or wafer bow requirement is achieved on the substrate 51.

The thickness of the final compressive SiN layer 54 is 400 nm instead of 200 nm. This is done to provide an effective protective layer over the outermost tensile layer 52. Variations in thickness are possible to achieve a required bow compensation. A ratio of thicknesses of tensile layer to compressive layer of around 5 to 1 as been found to provide excellent results, with a maximum thickness of 2.5 microns at 400 MPa.

In Figure 6, it can be seen that the thickness of the SiN stack can exceed 6 microns, resulting in a bow of about 250 microns without cracking, while the single SiN layer cracks at a thickness of about 2.7 microns.

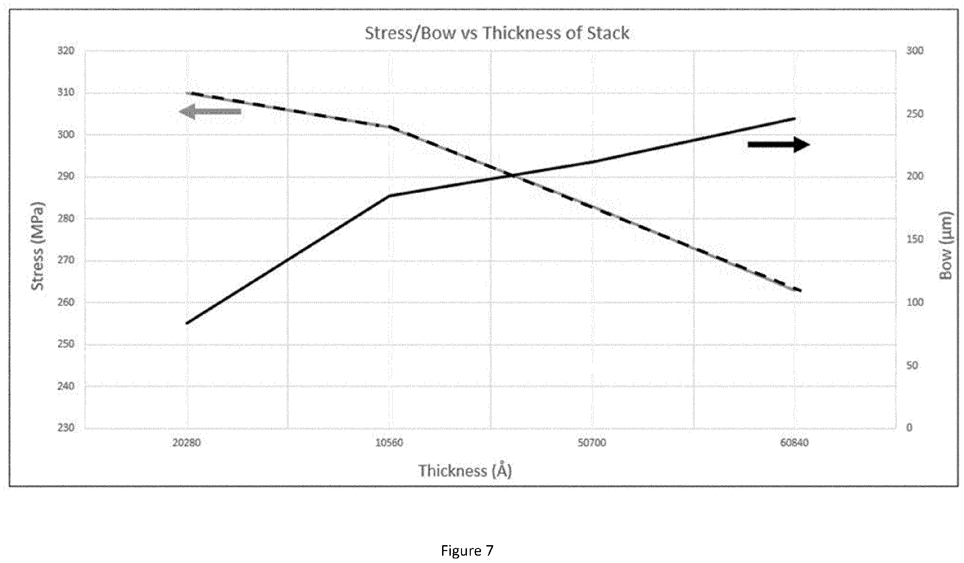

Figure 6 shows the wafer bow as measured using a stress gauge (FLX 3300LR), at different thicknesses. Bulk tensile SiN films exhibit larger wafer bow than the stack of alternating compressive and tensile SiN layers, because the overall bow of the stack is the sum of all the layers, with the bow of the compressive layers opposing the bow of the tensile layers. The critical thickness of 2.7 µm is also marked on the graph, which is the point that microcracking is observed on the wafers for bulk SiN. It is worth mentioning that cracking at this thickness is observed only under microscope so the cracking threshold for the bulk SiN is less than 2.7µm. As the bow of the wafer is directly related to the thickness, by increasing the stack thickness further, the wafer bow increases almost linearly, meeting a broad range of end requirements. Bow and stress values for the SiN stack structure can be seen in Figure 7.

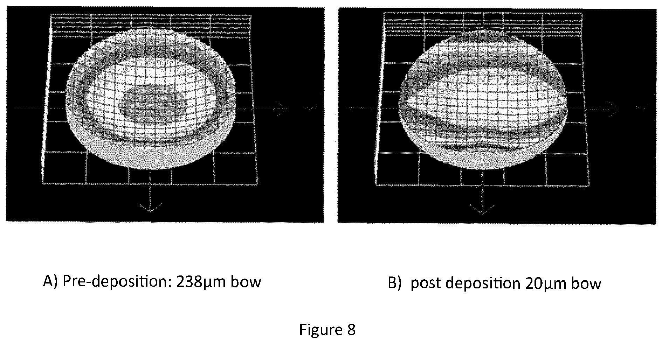

Figure 8 shows deflection maps, from the stress gauge, a) prior to the stack deposition where there is a 238µm bow and b) following the deposition of the SiN stack, where the bow is successfully reduced to about 20µm with no cracking.

Both tensile and compressive PECVD SiN layers were deposited in the same process chamber. However, in principle these steps could be carried out in separate chambers or ones in a multi wafer chamber.

## Claims

1. A method of depositing silicon nitride onto a semiconductor substrate by plasma enhanced chemical vapour deposition (PECVD), the method comprising the steps of:
providing a semiconductor substrate having a front surface and a rear surface, in which the front surface comprises a central region having one or more structures formed thereon and an edge region surrounding the central region;
positioning the front surface of the semiconductor substrate on a substrate support in a chamber, wherein the substrate support only contacts the edge region of the front surface of the semiconductor substrate; and
depositing a stack of silicon nitride layers onto the rear surface of the semiconductor substrate by PECVD, wherein the stack of silicon nitride layers comprises at least four layers of silicon nitride which alternate between tensile layers which are subject to a tensile stress and compressive layers which are subject to a compressive stress.

2. A method according to claim 1 in which the stack of silicon nitride layers comprises at least eight layers of silicon nitride.

3. A method according to claim 1 or claim 2 in which the stack of silicon nitride layers has a thickness of 3 microns or greater, optionally 5 microns or greater.

4. A method according to any one of claims 1 to 3 in which the layers of silicon nitride each have a thickness, and the thickness of the tensile layers is greater than the thickness of the compressive layers.

5. A method according to any one of claims 1 to 4 in which the tensile layers are at least twice as thick as the compressive layers.

6. A method according to any previous claim in which the tensile layers are at least four times as thick as the majority of the compressive layers.

7. A method according to any previous claim in which the thickness of the tensile layers is in the range 0.5 to 2.7 microns.

8. A method according to any previous claim in which the stack of silicon nitride layers is deposited by PECVD using nitrogen, hydrogen, ammonia and silane as precursors.

9. A method according to any previous claim in which, prior to the step of depositing the stack of silicon nitride layers, the semiconductor substrate has a concave bow when viewing the front surface of the semiconductor substrate.

10. A method according to any previous claim in which the step of depositing the stack of silicon nitride layers onto the rear surface of the semiconductor substrate by PECVD is performed using a capacitively coupled parallel plate PECVD process.

11. A method according to any previous claim in which (a) at least one gas inlet is provided for introducing a gas or gas mixture into the chamber, and the semiconductor substrate is positioned on the substrate support with the rear surface facing towards the at least one gas inlet; and/or (b) during the step of depositing a stack of silicon nitride layers onto the rear surface of the semiconductor substrate by PECVD, the plasma associated with the PECVD does not contact the front surface of the semiconductor substrate.

12. A method according to any previous claim in which the semiconductor substrate has a peripheral edge, and the substrate support only contacts the edge region of the front surface of the semiconductor substrate in a region no more than 3mm inward of the peripheral edge.

13. A structure comprising:
a semiconductor substrate having a front surface and a rear surface, in which the front surface comprises a central region and an edge region surrounding the central region;
one or more structures formed on the central region of the front surface of the semiconductor substrate; and
a stack of silicon nitride layers deposited onto the rear surface of the semiconductor substrate, wherein the stack of silicon nitride layers comprises at least four layers of silicon nitride which alternate between tensile layers which are subject to a tensile stress and compressive layers which are subject to a compressive stress.

14. A structure according to claim 13 produced using a method in accordance with claim 1.

15. A plasma enhanced chemical vapour deposition (PECVD) apparatus for depositing silicon nitride onto a semiconductor substrate by PECVD using a method according to claim 1, the apparatus comprising:
a chamber;
a substrate support disposed within the chamber for supporting a substrate, wherein the substrate support only contacts an edge region of the substrate;
at least one gas inlet for introducing a gas or gas mixture into the chamber;
a plasma device for generating and sustaining a plasma in the chamber; and
a controller configured to control the apparatus to deposit a stack of silicon nitride layers onto the semiconductor substrate by PECVD, wherein the stack of silicon nitride layers comprises at least four layers of silicon nitride which alternate between tensile layers which are subject to a tensile stress and compressive layers which are subject to a compressive stress;
wherein optionally the plasma device comprises at least one power supply device configured to supply a RF power signal to the at least one gas inlet.
